# EUROPEAN PATENT APPLICATION

(11) **EP 4 625 707 A1**
(43) Date of publication of application: **01.10.2025**
(21) Application number: 25156232.8
(22) Date of filing: 06.02.2025
(51) Int. Cl.: H01R 12/57, H01R 12/72, H01R 24/60

(54) **MOUNTED SUBSTRATE AND ELECTRONIC APPARATUS**

(30) Priority: 25.03.2024 JP 2024048214
(71) Applicant: Lenovo (Singapore) Pte. Ltd., New Tech Park 556741 (SG)
(72) Inventor: MIZOGUCHI, Fumitake, Yokohama-shi, 220-0012 (JP); OHSAWA, Osamu, Yokohama-shi, 220-0012 (JP); NAKATA, Munefumi, Yokohama-shi, 220-0012 (JP); IWASAKI, Jun, Yokohama-shi, 220-0012 (JP)
(74) Representative: Openshaw & Co.

(57) **Abstract**

An object of the present invention is to restrain electrostatic discharge damage at the time of attachment of a receptacle connector.

A mounted substrate includes a substrate, a surface mount connector having a connector connecting hole, and a receptacle connector including a relay connector. The surface mount connector has a first contact point provided on a first inner surface of the connector connecting hole which first inner surface is on one side in a height direction of the connector connecting hole, and a second contact point provided on a second inner surface on the other side in the height direction. The relay connector includes a board piece to be inserted into the connector connecting hole, a first terminal provided on one surface of the board piece and connected to the first contact point, and a second terminal provided on the other surface of the board piece and connected to the second contact point. The first contact point is disposed closer to an opening side than the second contact point in a depth direction of the connector connecting hole. The first terminal includes a first ground pin and a first signal pin, and the first ground pin has a distal end projecting toward a distal end side of the board piece relative to a distal end of the first signal pin.

## Description

### BACKGROUND OF THE INVENTION

### Field of the Invention

The present invention relates to a mounted substrate including a receptacle connector, and an electronic apparatus including the mounted substrate.

### Description of the Related Art

An electronic apparatus such as a laptop PC or a tablet PC includes a receptacle connector as an I/O connector on a lateral surface of a flat chassis. The receptacle connector is often provided on an edge of a main substrate (see Japanese Unexamined Patent Application Publication No. 2019-36484).

### SUMMARY OF THE INVENTION

In recent years, as the electronic apparatus as described above, a product superior in maintainability has been desired from the viewpoint of ESG (Environment, Social, Governance). In this regard, it is desirable that the receptacle connector be easily replaceable. Particularly, in a case where receptacle connectors conform to the USB Type-C technical standard or the like that is frequently used, the number of receptacle connectors resulting in failure is large, and therefore, it is still more desirable that such receptacle connectors be easily replaceable.

In the meantime, at the time of replacement of a receptacle connector, when the connector is incorporated in a system while the connector is electrically charged, charged static electricity is discharged. This causes a large current to flow from an internal circuit into an electronic component, which might cause electrostatic discharge damage (ESD damage) that breaks the electronic component.

The present invention is accomplished in view of the above technical problem, and an object of the present invention is to provide a mounted substrate and an electronic apparatus each of which can restrain electrostatic discharge damage at the time of attachment of a receptacle connector.

A mounted substrate according to the first aspect of the present invention includes: a substrate having a mounting surface; a surface mount connector which has a connector connecting hole opened along a surface direction of the substrate and which is mounted on the mounting surface of the substrate; and a receptacle connector having a plug connection opening to which a plug is connected, the receptacle connector including a relay connector detachably connected to the connector connecting hole. The surface mount connector has a first contact point provided on a first inner surface of the connector connecting hole which first inner surface is on one side in a height direction of the connector connecting hole, and a second contact point provided on a second inner surface on the other side in the height direction. The relay connector includes a board piece to be inserted into the connector connecting hole, a first terminal provided on one surface of the board piece and connected to the first contact point, and a second terminal provided on the other surface of the board piece and connected to the second contact point. The first contact point is disposed closer to an opening side than the second contact point in a depth direction of the connector connecting hole. The first terminal includes a first ground pin and a first signal pin. The first ground pin has a distal end projecting toward a distal end side of the board piece relative to a distal end of the first signal pin.

An electronic apparatus according to a second aspect of the present invention is an electronic apparatus including a chassis, and a mounted substrate supported on the chassis. The mounted substrate includes: a substrate having a mounting surface; a surface mount connector which has a connector connecting hole opened along a surface direction of the substrate and which is mounted on the mounting surface of the substrate; and a receptacle connector having a plug connection opening to which a plug is connected, the receptacle connector including a relay connector detachably connected to the connector connecting hole. The surface mount connector has a first contact point provided on a first inner surface of the connector connecting hole which first inner surface is on one side in a height direction of the connector connecting hole, and a second contact point provided on a second inner surface on the other side in the height direction. The relay connector includes a board piece to be inserted into the connector connecting hole, a first terminal provided on one surface of the board piece and connected to the first contact point, and a second terminal provided on the other surface of the board piece and connected to the second contact point. The first edge portion is disposed closer to an opening side than the second contact point in a depth direction of the connector connecting hole. The first terminal includes a first ground pin and a first signal pin. The first ground pin has a distal end projecting toward a distal end side of the board piece relative to a distal end of the first signal pin.

The aspects of the present invention can restrain electrostatic discharge damage at the time of attachment of a receptacle connector.

### BRIEF DESCRIPTION OF THE DRAWINGS

FIG. 1 is a perspective view of an electronic apparatus according to one embodiment;
FIG. 2 is a perspective view of a receptacle connector and a surface mount connector viewed from outside and diagonally above;
FIG. 3 is a sectional perspective view of the receptacle connector and the surface mount connector viewed from outside and diagonally below;
FIG. 4 is a schematic side sectional view of a chassis around the receptacle connector and its peripheral area;
FIG. 5A is a schematic bottom plan view of the receptacle connector viewed from one surface side;
FIG. 5B is a schematic plan view of the receptacle connector viewed from the other surface side;
FIG. 6A is an explanatory drawing illustrating a state right before a relay connector is connected to a surface mount connector;
FIG. 6B is an explanatory drawing illustrating a state right after ground pins illustrated in FIG. 6A make contact with first contact points;
FIG. 7 is a schematic side sectional view illustrating an operation to connect the receptacle connector to the surface mount connector;
FIG. 8 is a view illustrating a state where the ground pin of the first terminal illustrated in FIG. 7 makes contact with the first contact point of the surface mount connector; and
FIG. 9 is a view in which the receptacle connector illustrated in FIG. 8 is tilted down.

### DETAILED DESCRIPTION OF THE INVENTION

The following will describe details of a preferred embodiment of a mounted substrate and an electronic apparatus according to the present invention with reference to the attached drawings.

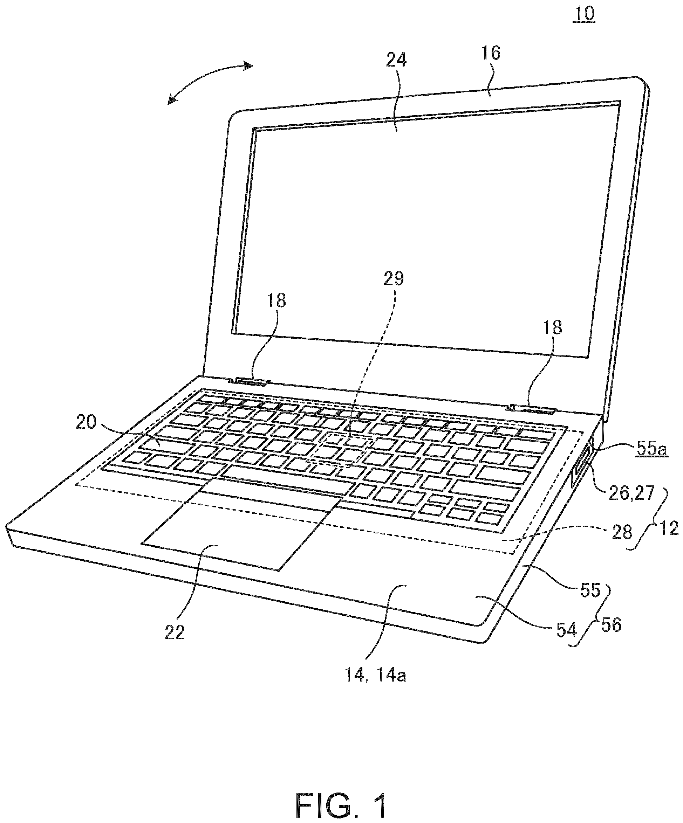

FIG. 1 is a perspective view of an electronic apparatus 10 according to one embodiment. The electronic apparatus 10 is provided with a mounted substrate 12 according to one embodiment. The mounted substrate 12 is incorporated into a chassis 14 of the electronic apparatus 10. The following describes an embodiment of the present invention with reference to the electronic apparatus 10 as a laptop PC. The present invention can be applied to electronic apparatuses other than the laptop PC, e.g., a desktop PC, a tablet PC (a tablet terminal), and the like.

The electronic apparatus 10 includes the chassis 14, a cover 16, and a hinge 18. The chassis 14 and the cover 16 are coupled to each other via the hinge 18 in such a manner to be rotatable relative to each other.

The chassis 14 is provided with a keyboard 20 and a touch pad 22. Various electronic parts such as a battery device, a storage device, a speaker, and an antenna can be provided inside the chassis 14 other than the mounted substrate 12. A display device 24 is provided on a front surface of the cover 16 in such a manner as to cover most of the area of the front surface. The display device 24 can be constituted by a liquid crystal display, an organic EL display, or the like, for example. A speaker, a camera, and the like can be provided on the cover 16.

The mounted substrate 12 is supported inside the chassis 14. The mounted substrate 12 can include a receptacle connector 26, a surface mount connector 27, and a substrate 28. The mounted substrate 12 is a connector-substrate assembly in which the receptacle connector 26 is mounted on the substrate 28 via the surface mount connector 27.

The substrate 28 is a main substrate (a mother board) in the electronic apparatus 10. The substrate 28 is a printed circuit board (PCB). The substrate 28 extends generally over right and left ends of the chassis 14 inside the chassis 14. A CPU 29 configured to control the whole electronic apparatus 10 is mounted on the substrate 28. The surface mount connector 27 is mounted on the substrate 28. The receptacle connector 26 is mounted on the substrate 28 via the surface mount connector 27. The substrate 28 on which the surface mount connector 27 is mounted may be a sub-substrate different from the main substrate.

For convenience of this description, around the receptacle connector 26, a lateral side of the chassis 14 is defined as outside, and an inner portion of the chassis 14 which inner portion is opposite from the outside is defined as inside. On the basis of the substrate 28, a mounting surface 28a side on which the surface mount connector 27 is provided is defined as top, and its opposite side is defined as bottom. The definitions of the top and the bottom may be reversed to the top and the bottom of the chassis 14 illustrated in FIG. 1. That is, when the top and the bottom on the basis of the substrate 28 are applied to the chassis 14, a surface provided with the keyboard 20 may become the bottom. In terms of the receptacle connector 26 and the surface mount connector 27, a direction perpendicular to the inside-outside direction and the top-bottom direction is defined as a width direction. The names of these directions are for the sake of convenience for description, and the usage of the electronic apparatus 10 is not limited to this.

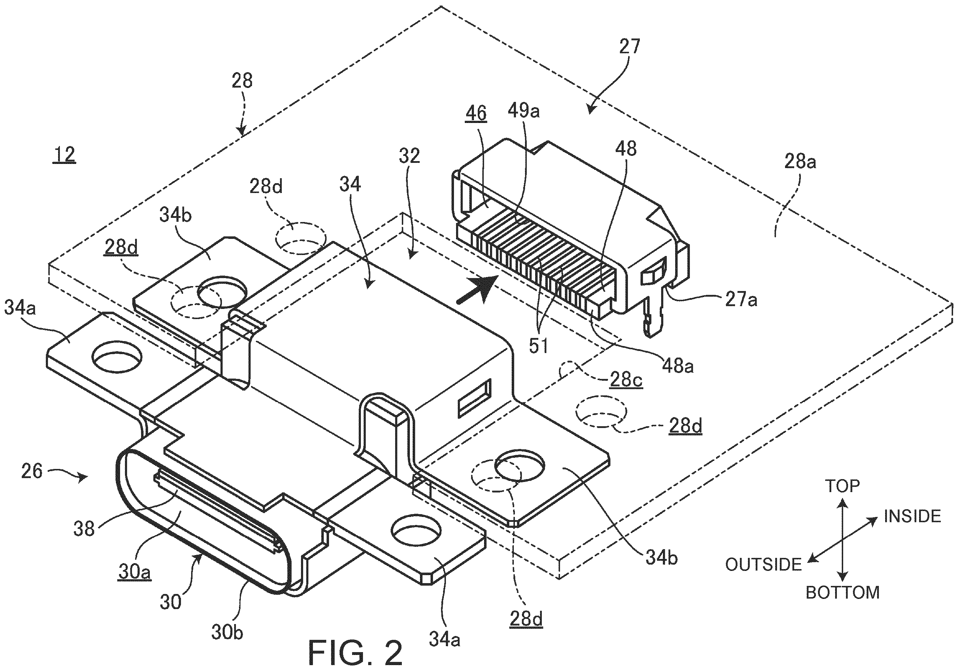

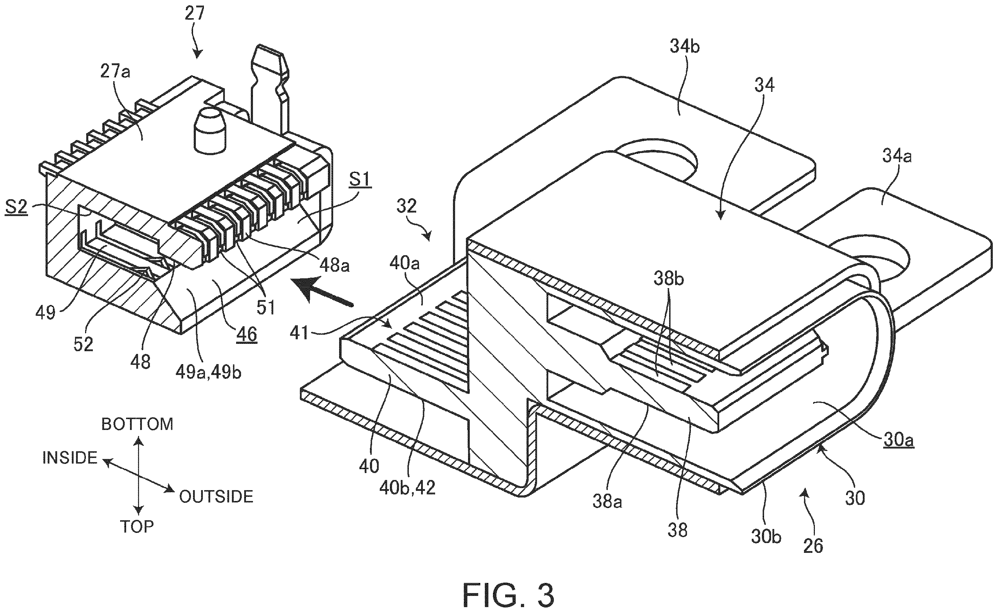

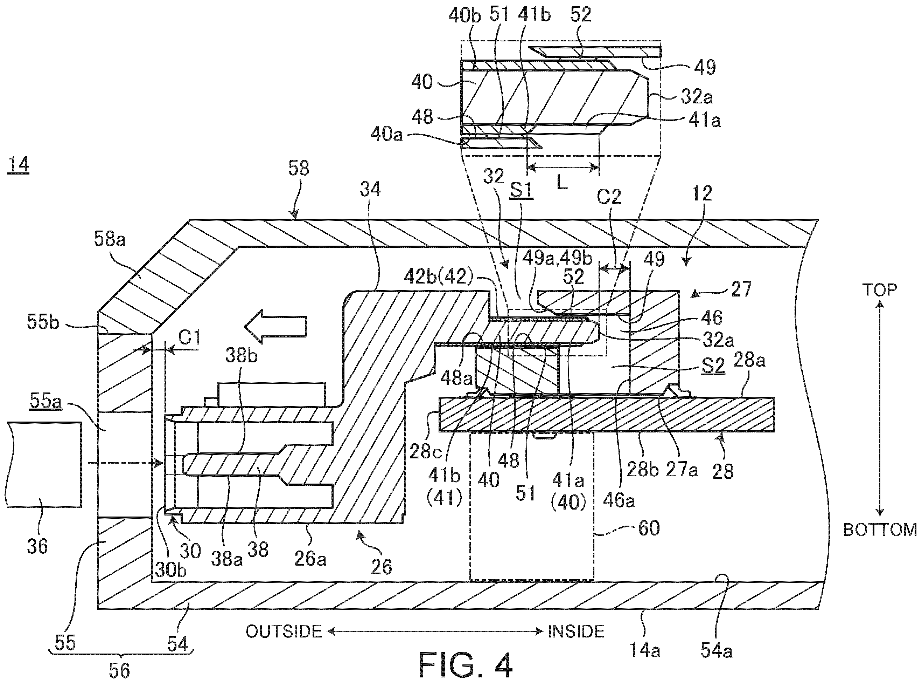

FIG. 2 is a perspective view of the receptacle connector 26 and the surface mount connector 27 viewed from outside and diagonally above. FIG. 3 is a sectional perspective view of the receptacle connector 26 and the surface mount connector 27 viewed from outside and diagonally below. FIG. 4 is a schematic side sectional view of the chassis 14 around the receptacle connector 26 and its peripheral area.

First described is an exemplary configuration of the receptacle connector 26.

As illustrated in FIGS. 2 to 4, the receptacle connector 26 is a connector in conformity with the USB type-C standard, for example. The receptacle connector 26 can be used for data transmission or charge. The receptacle connector 26 may also conform to the HDMI (registered trademark) standard or the like. The receptacle connector 26 is mounted on the substrate 28 via the surface mount connector 27. Hereby, the receptacle connector 26 is not soldered to the substrate 28, so that the receptacle connector 26 is attachable and detachable.

The receptacle connector 26 includes a plug hold cylindrical body 30, a relay connector 32, and a shell 34.

The relay connector 32 of the receptacle connector 26 is connected to the surface mount connector 27 mounted on the mounting surface 28a. Hereby, the plug hold cylindrical body 30 is disposed to fit into a cutout 28c formed in the substrate 28. This allows the receptacle connector 26 to be mounted on the mounting surface 28a of the substrate 28 by a so-called mid-mount method.

The plug hold cylindrical body 30 is a metal tubular body. The plug hold cylindrical body 30 has a flat elliptical shape with four round corners. The plug hold cylindrical body 30 is on the outermost side of the receptacle connector 26 and is placed below the relay connector 32.

A vertical wall 55 forming a lateral surface of the chassis 14 has a through-hole (a connector hole) 55a (also see FIG. 1). The plug hold cylindrical body 30 is disposed to face the through-hole 55a. Hereby, a plug connection opening 30a of the plug hold cylindrical body 30 is exposed to outside the chassis 14 via the through-hole 55a. A plug 36 can be inserted in and connected to the plug connection opening 30a (see FIG. 4). The plug 36 is a plug connector attached to a cable or a device. The connection standard for the plug connection opening 30a and the plug 36 conforms to the USB type-C standard, for example. The plug 36 can be inserted into and connected to the plug connection opening 30a regardless of face-up or face-down.

A board piece 38 having a tongue shape is provided inside the plug hold cylindrical body 30. The board piece 38 has contact points 38a, 38b on a top surface and a bottom surface thereof, respectively. A terminal of the plug 36 makes contact with each of the contact points 38a, 38b. The contact points 38a, 38b are each constituted by a plurality of metallic pins arranged in parallel in the width direction of the board piece 38. The contact points 38a, 38b are connected to terminals 41, 42 of the relay connector 32 by use of respective electrode lines, respectively. The contact points 38a, 38b and the terminals 41, 42 each have 24 metallic pins, for example.

The relay connector 32 is on the innermost side of the receptacle connector 26. The relay connector 32 is placed above the mounting surface 28a. The relay connector 32 can have a plug structure. The relay connector 32 can be detachably connected to a connector connecting hole 46 of the surface mount connector 27.

The relay connector 32 can include a board piece 40 having a tongue shape, a first terminal 41 provided on a bottom surface (one surface 40a) of the board piece 40, and a second terminal 42 provided on a top surface (the other surface 40b) of the board piece 40. The terminals 41, 42 are each constituted by a plurality of metallic pins arranged in parallel in the width direction of the board piece 40, for example. The terminals 41, 42 each have 12 metallic pins, for example.

The shell 34 is a thin metal plate component. The shell 34 covers an outer peripheral surface of the plug hold cylindrical body 30 except the plug connection opening 30a, and a top surface and a lateral surface of the relay connector 32. The shell 34 includes a pair of fixing pieces 34a, 34a and a pair of fixing pieces 34b, 34b in the width direction. The fixing pieces 34a project to the opposite directions from respective lateral surfaces of the plug hold cylindrical body 30. The fixing pieces 34b project to the opposite directions from respective lateral surfaces of the relay connector 32. The fixing pieces 34a, 34b can be used to fix the receptacle connector 26 to the substrate 28. The fixing pieces 34a, 34b each has a screw insertion hole. The substrate 28 has a screw insertion hole 28d formed at a position corresponding to each of the fixing pieces 34a, 34b (see FIG. 2). The fixing pieces 34b may be omitted.

A stud 60 is formed in a standing manner on a plate portion 54 forming an inner surface of the chassis 14 (see FIG. 4). The stud 60 has an internal thread formed on a top surface (an upper end surface) thereof. The top surface of the stud 60 abuts with a back surface 28b of the substrate 28 which back surface 28b is opposite from the mounting surface 28a. A screw passed through the screw insertion hole of the fixing piece 34a, 34b and the screw insertion hole 28d of the substrate 28 is threadedly engaged with the internal thread of the stud 60. Hereby, the shell 34 is fastened to the substrate 28, and the receptacle connector 26 is fixed to the substrate 28. At the same time, a portion of the substrate 28 which portion is around the receptacle connector 26 is also supported on the chassis 14.

Next will be described an exemplary configuration of the surface mount connector 27.

As illustrated in FIGS. 2 to 4, the surface mount connector 27 can be mounted such that a connection surface 27a of the surface mount connector 27 is fixed to the mounting surface 28a of the substrate 28 by soldering. The relay connector 32 of the receptacle connector 26 can be detachably connected to the surface mount connector 27. In the present embodiment, the relay connector 32 has a plug structure, and therefore, the surface mount connector 27 has a socket structure. The surface mount connector 27 and the relay connector 32 can each be constituted by a board-to-board connector.

The surface mount connector 27 has the connector connecting hole 46. The connector connecting hole 46 extends along a surface direction of the substrate 28 and is opened to face outside. The connector connecting hole 46 has an opening edge portion including a first edge portion 48a and a second edge portion 49a. The first edge portion 48a is an edge portion closer to the mounting surface 28a side (the bottom side). The second edge portion 49a is an edge portion on the opposite side (the top side) from the mounting surface 28a side. The edge portions 48a, 49a extend in the width direction of the connector connecting hole 46.

Contact points 51, 52 are provided on an inner surface of the connector connecting hole 46. The contact points 51, 52 make contact with the terminals 41, 42 of the relay connector 32 in a conducting manner, respectively.

The inner surface of the connector connecting hole 46 includes a first inner surface 48 and a second inner surface 49. The first inner surface 48 is a bottom surface on one side (the bottom side) of the connector connecting hole 46 in its height direction (the top-bottom direction). The first inner surface 48 extends inwardly from the first edge portion 48a in a depth direction (the inside-outside direction) of the connector connecting hole 46. The second inner surface 49 is a ceiling surface on the other side (the top side) of the connector connecting hole 46 in the height direction. The second inner surface 49 extends inwardly from the second edge portion 49a in the depth direction of the connector connecting hole 46.

The first contact point 51 is provided on the first inner surface 48. The second contact point 52 is provided on the second inner surface 49. Each of the contact points 51, 52 is connected to a signal line or a ground pattern formed on the substrate 28. The contact points 51, 52 are each constituted by a plurality of metallic pins arranged in parallel in the width direction of the connector connecting hole 46. The contact points 51, 52 each have 12 metallic pins, for example. The terminals 41, 42 of the relay connector 32 make contact with the contact points 51, 52 in a conducting manner.

As illustrated in FIG. 4, the second edge portion 49a is disposed on a deep side relative to the first edge portion 48a in the depth direction of the connector connecting hole 46. In other words, the first edge portion 48a is disposed on an opening side relative to the second edge portion 49a in the depth direction of the connector connecting hole 46. Accordingly, the first edge portion 48a as a lower jaw of the connector connecting hole 46 projects outwardly from the second edge portion 49a as an upper jaw thereof. Hereby, the opening edge portion of the connector connecting hole 46 forms an open space S1 opened upward. The open space S1 is a space allowing a root portion of the relay connector 32 inserted into the connector connecting hole 46 to swing upward.

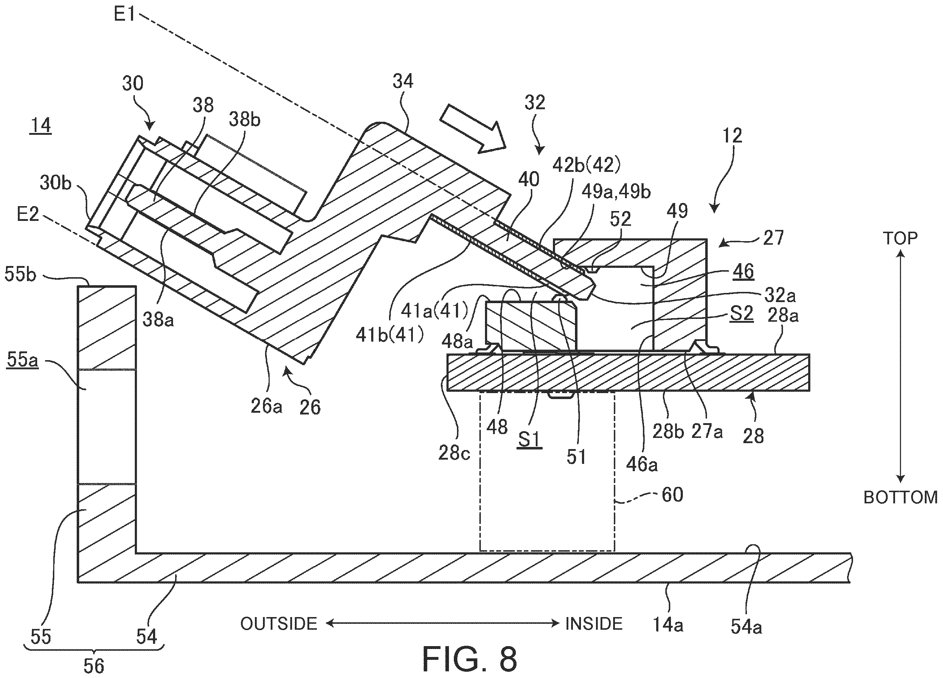

The second edge portion 49a facing the open space S1 has an inclined surface 49b. The inclined surface 49b is gradually inclined in a direction (upward) separating from the mounting surface 28a, from the deep side (the inside) of the connector connecting hole 46 toward the opening side (the outside) thereof. The inclination angle of the inclined surface 49b from the surface direction of the substrate 28 is not limited but can be set to about 20 degrees to 40 degrees, for example. In the present embodiment, the inclination angle is about 30 degrees. The inclination angle of the inclined surface 49b can be designed in consideration of a standing height of the vertical wall 55 (described later), the height of the receptacle connector 26 in the up-down direction, and the like. It is desirable that the inclination angle of the inclined surface 49b be an angle at which extension lines E1, E2 in FIG. 8 do not intersect with the vertical wall 55, for example.

The connector connecting hole 46 can have an expansion space S2 formed such that a portion of the first inner surface 48 which portion is on the deep side from the first contact point 51 is recessed toward the mounting surface 28a side (the bottom side). The expansion space S2 is a space formed by expanding a deep portion of the connector connecting hole 46 downward. The expansion space S2 is a space allowing a distal end portion of the relay connector 32 inserted into the connector connecting hole 46 to swing downward.

As illustrated in FIG. 4, the chassis 14 can include a chassis member 56 including the plate portion 54 and the vertical wall 55, and a cover material 58.

The chassis member 56 can have a shallow bathtub shape by forming the vertical wall 55 in an outer peripheral edge portion of the plate portion 54. The plate portion 54 forms an operation surface 14a of the chassis 14. The operation surface 14a is a surface on which the keyboard 20 and the touch pad 22 are exposed (see FIG. 1). The plate portion 54 has an inner surface 54a on which the stud 60 can be formed in a standing manner. The studs 60 are placed in positions corresponding to at least four fixing pieces 34a, 34b. As described above, the studs 60 can be used to fasten the receptacle connector 26 to the substrate 28. A portion of the substrate 28 which portion is not around the receptacle connector 26 is also supported on the inner surface 54a of the plate portion 54 as appropriate.

The vertical wall 55 stands upward from an outer peripheral edge portion of the plate portion 54. The vertical wall 55 forming the lateral surface of the chassis 14 has the through-hole 55a (also see FIG. 1). The plug connection opening 30a of the receptacle connector 26 faces the through-hole 55a. The through-hole 55a is an opening via which the plug 36 is connected to the plug connection opening 30a.

The cover material 58 is a plate-shaped member for blocking the opening of the chassis member 56. A tapered portion 58a can be provided in an edge portion of the cover material 58. The tapered portion 58a is inclined inwardly from a distal end (an upper end 55b) of the vertical wall 55. The receptacle connector 26 can be disposed such that a step formed in the top-bottom direction between the relay connector 32 and the plug hold cylindrical body 30 is placed below an inner surface of the tapered portion 58a.

As illustrated in FIG. 4, the receptacle connector 26 is mounted on the substrate 28 via the surface mount connector 27 and can be supported on the substrate 28 and the chassis 14 via the studs 60. In this state, a predetermined clearance C1 can be provided between an open end (the outer end surface 30b) of the plug connection opening 30a and the inner surface of the vertical wall 55. The clearance C1 is an opposed distance between the vertical wall 55 and the plug connection opening 30a. The clearance C1 can be 0.2 mm, for example. The distal end of the plug hold cylindrical body 30 may make contact with the inner surface of the vertical wall 55 or may be inserted into the through-hole 55a. In this case, the clearance C1 is zero or becomes negative.

In this state, a predetermined clearance C2 can be provided between a depth surface 46a of the connector connecting hole 46 and a distal end surface 32a of the relay connector 32. The clearance C2 can be 0.5 mm, for example. That is, the clearance C2 can be set larger than the clearance C1. The clearance C2 forms a space in which the relay connector 32 is moved towards the deep side of the connector connecting hole 46 at the time of a removal operation and an attachment operation of the receptacle connector 26 (described later).

Next will be described a specific exemplary configuration of the relay connector 32, and a connection structure for the relay connector 32 and the surface mount connector 27.

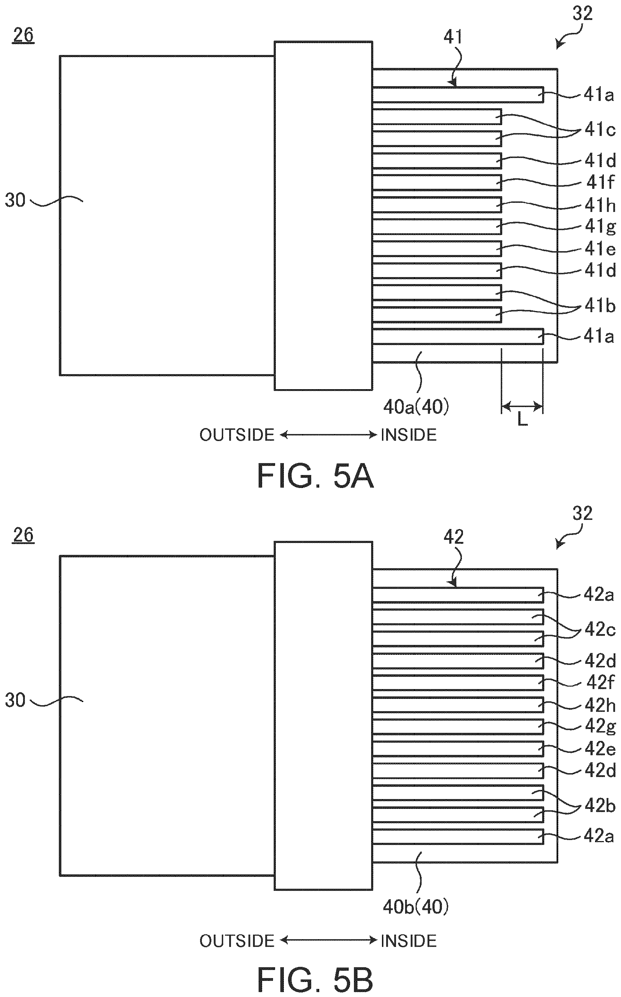

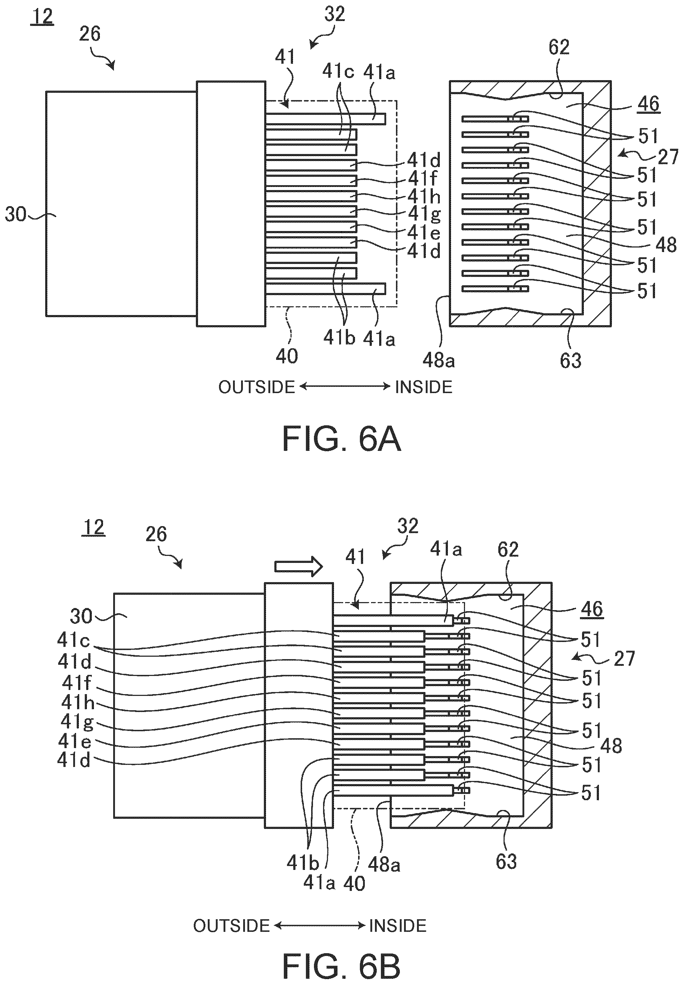

FIG. 5A is a schematic bottom plan view of the receptacle connector 26 viewed from one surface 40a side. FIG. 5B is a schematic plan view of the receptacle connector 26 viewed from the other surface 40b side. FIG. 6A is an explanatory drawing illustrating a state right before the relay connector 32 is connected to the surface mount connector 27. FIG. 6B is an explanatory drawing illustrating a state right after a ground pin 41a illustrated in FIG. 6A makes contact with the first contact point 51. FIGS. 6A and 6B are plan views each illustrating the first contact points 51 viewed from above in a section of the surface mount connector 27 which section is taken along a plane perpendicular to the top-bottom direction. Elements other than the first terminal 41 in the relay connector 32 are omitted, and the first terminal 41 is illustrated in a plan view viewed from above.

As illustrated in FIG. 5A, the first terminal 41 of the relay connector 32 includes a plurality of metallic pins arranged in parallel in the width direction on the one surface 40a of the board piece 40. The metallic pins constituting the first terminal 41 include two ground pins 41a, 41a, two high-speed transmission pins 41b, 41b, two high-speed reception pins 41c, 41c, two power-supply pins 41d, 41d, a plug orientation detection pin 41e, an extension pin 41f, a low-speed transmission pin 41g, and a low-speed reception pin 41h.

The ground pin 41a is a ground pin connected to a ground pattern of the substrate 28 via the first contact point 51. The high-speed transmission pin 41b, the high-speed reception pin 41c, the plug orientation detection pin 41e, the extension pin 41f, the low-speed transmission pin 41g, and the low-speed reception pin 41h are signal pins connected to signal lines of the substrate 28 via the first contact points 51. The power-supply pin 41d is a power-supply pin connected to a power source line of the substrate 28 via the first contact point 51.

The ground pins 41a are disposed at the opposite ends of the board piece 40 in the width direction. The two high-speed transmission pins 41b are arranged adjacent to one of the ground pins 41a. The two high-speed reception pins 41c are arranged adjacent to the other one of the ground pins 41a. One of the power-supply pins 41d is disposed adjacent to the high-speed transmission pin 41b, and the other one of them is adjacent to the high-speed reception pin 41c. The plug orientation detection pin 41e is disposed adjacent to the power-supply pin 41d that is adjacent to the high-speed transmission pin 41b. The extension pin 41f is disposed adjacent to the power-supply pin 41d that is adjacent to the high-speed reception pin 41c. The low-speed transmission pin 41g is disposed adjacent to the plug orientation detection pin 41e. The low-speed reception pin 41h is disposed adjacent to the extension pin 41f.

As illustrated in FIG. 5B, the second terminal 42 of the relay connector 32 includes a plurality of metallic pins arranged in parallel in the width direction on the other surface 40b of the board piece 40. The metallic pins constituting the second terminal 42 include two ground pins 42a, 42a, two high-speed transmission pins 42b, 42b, two high-speed reception pins 42c, 42c, two power-supply pins 42d, 42d, a plug orientation detection pin 42e, an extension pin 42f, a low-speed transmission pin 42g, and a low-speed reception pin 42h.

The ground pin 42a is a ground pin connected to a ground pattern of the substrate 28 via the second contact point 52. The high-speed transmission pin 42b, the high-speed reception pin 42c, the plug orientation detection pin 42e, the extension pin 42f, the low-speed transmission pin 42g, and the low-speed reception pin 42h are signal pins connected to signal lines of the substrate 28 via the second contact points 52. The power-supply pin 42d is a power-supply pin connected to a power source line of the substrate 28 via the second contact point 52. The arrangement order of the pins 42a to 42h of the second terminal 42 are reverse to the arrangement order of the pins 41a to 41h of the first terminal 41 in the top-down direction. The numbers or the arrangement orders of the metallic pins of the terminals 41, 42 will be changed depending on a connection standard corresponding to the receptacle connector 26, and this also applies to the contact points 51, 52 corresponding to the terminals 41, 42.

As illustrated in FIG. 5A, in the first terminal 41 of the present embodiment, the ground pin (a first ground pin) 41a has a distal end projecting toward a distal end side (the inner side) of the board piece 40 relative to distal ends of the high-speed transmission pin 41b, the high-speed reception pin 41c, and so on as signal pins (first signal pins). In the first terminal 41, the distal end of the ground pin (the first ground pin) 41a projects toward the distal end side (the inner side) of the board piece 40 relative to the distal end of the power-supply pin 41d. That is, the distal end of the ground pin 41a is disposed on the distal end side of the board piece 40 relative to the distal ends of the other pins 41b to 41h.

As illustrated in FIG. 5B, in the second terminal 42 of the present embodiment, the ground pin (a second ground pin) 42a has a distal end disposed at the same position as distal ends of the high-speed transmission pin 42b and so on as signal pins (second signal pins). In the second terminal 42, the distal end of the ground pin (the second ground pin) 42a is disposed at the same position as the distal end of the power-supply pin 42d. Note that it is needless to say that the concept that the distal end of the ground pin 42a is disposed at the same position as the distal ends of the other pins 42b to 42h includes a case where the positions of those distal ends slightly deviate from each other due to a manufacturing tolerance, an assembly error, or the like, as well as a case where the positions of the distal ends are disposed completely at the same position in the inside-outside direction.

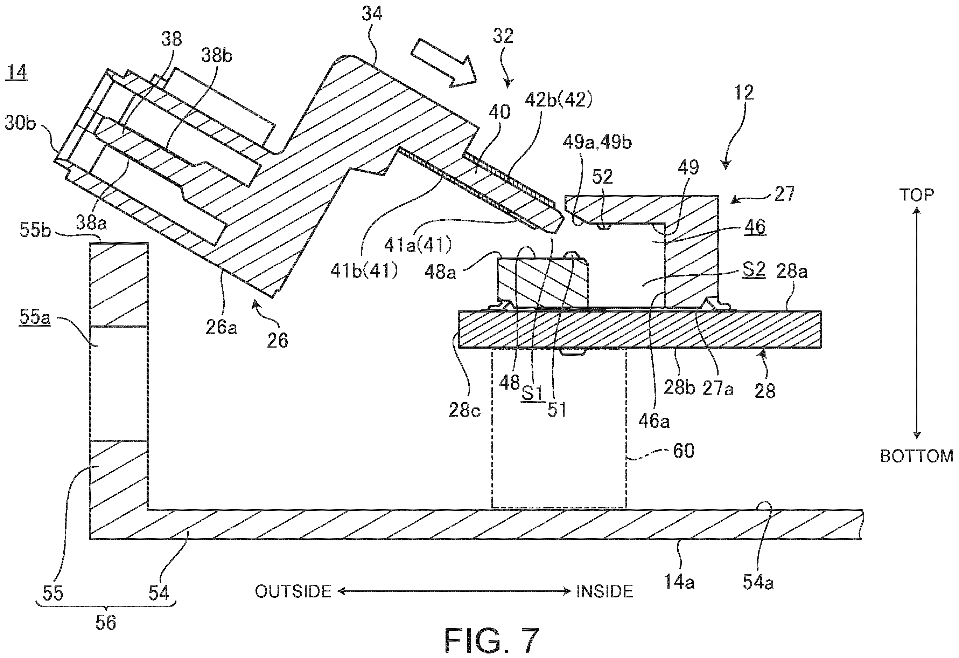

As illustrated in FIGS. 6A and 6B, such a relay connector 32 is connected to the surface mount connector 27. At the time when the relay connector 32 is connected to the surface mount connector 27, the ground pins 41a at both ends of the first terminal 41 make contact with the first contact points 51 earlier than the other pins 41b to 42h. Note that the second contact points 52 are disposed on the deep side (the inner side) of the connector connecting hole 46 relative to the first contact points 51 (see FIG. 7, and so on). Accordingly, at the timing when the ground pins 41a of the first terminal 41 make contact with the first contact points 51, the second terminal 42 has no contact with the second contact points 52 (see FIG. 8).

Next will be described an attachment operation of the receptacle connector 26 and its operation-effect.

As illustrated in FIGS. 7 to 9, the attachment operation of the receptacle connector 26 to the surface mount connector 27 is performed in a state where the cover material 58 is removed from the chassis member 56.

First, as indicated by blank arrows in FIGS. 7 and 8, the receptacle connector 26 is moved inwardly and diagonally downward so as to insert the relay connector 32 into the connector connecting hole 46.

At this time, in the surface mount connector 27, the first contact point 51 is disposed closer to the opening side (outward) than the second contact point 52 in the depth direction (the inside-outside direction) of the connector connecting hole 46. The distal end of the ground pin 41a of the first terminal 41 projects toward the distal end side of the board piece 40 relative to the distal ends of the high-speed transmission pin 41b and so on as signal pins. On this account, at the time when the relay connector 32 is connected to the surface mount connector 27, the ground pin 41a first makes contact with the first contact point 51. At this contact timing, the other pins 41b to 41h and the pins 42a to 42h of the second terminal 42 do not make contact with the contact points 51, 52 (see FIGS. 6B and 8).

That is, there is such a case where the relay connector 32 is charged with static electricity at the time when the relay connector 32 is connected to the surface mount connector 27. Even in such a case, the mounted substrate 12 of the present embodiment discharges the charged static electricity to the ground at the point when the ground pin 41a makes contact with the first contact point 51. This can avoid a heavy current due to the static electricity from flowing into the signal lines of the substrate 28 via the high-speed transmission pin 41b and so on as signal pins. As a result, the electronic apparatus 10 and the mounted substrate 12 can restrain electrostatic discharge damage (ESD damage) of other electronic components mounted on the substrate 28 and other electronic components mounted on the chassis 14 and the cover 16.

Herein, as illustrated in FIGS. 4 and 6B, a position difference between the distal end of the ground pin 41a and the distal end of the high-speed transmission pin 41b or the like is referred to as a distance L. The distance L can be set appropriately in consideration of the positional relationship between the pins 41a to 41h of the first terminal 41 and the first contact points 51, and the like. For example, as illustrated in FIGS. 6B and 8, the distance L can be set to a distance that prevents the other pins 41b to 41h from making contact with the first contact points 51 at a position where the ground pin 41a just makes contact with the first contact point 51. For example, the distance L can be a distance that surely allows the other pins 41b to 41h to make contact with the first contact points 51 at a position where the relay connector 32 is completely connected to the surface mount connector 27 as illustrated in FIG. 4.

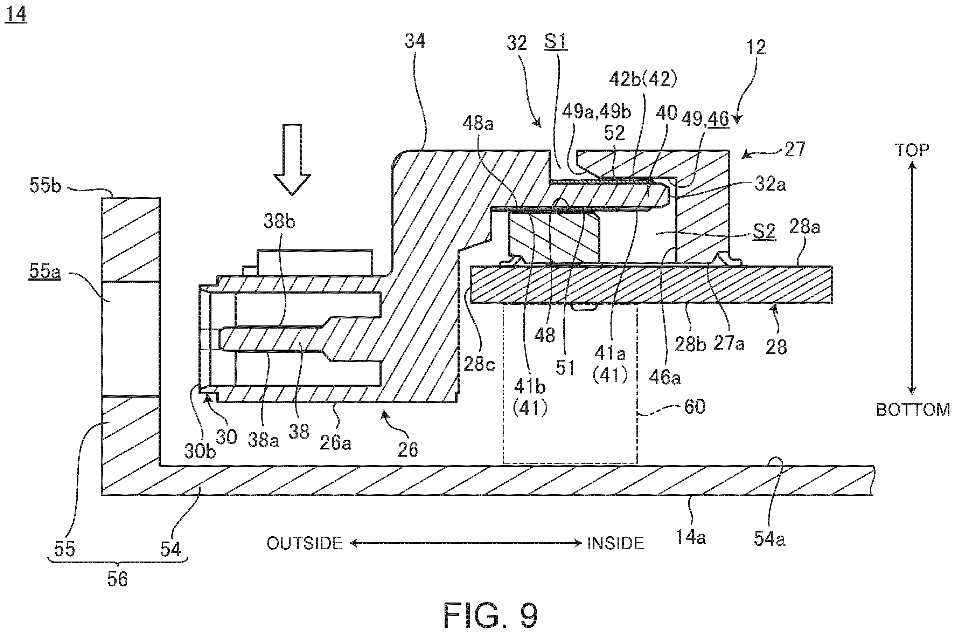

Subsequently, as indicated by a blank arrow in FIG. 9, the receptacle connector 26 is pushed down in a direction where the plug hold cylindrical body 30 moves downward. This causes the receptacle connector 26 to rotate counterclockwise in FIG. 9 with a connecting portion between the relay connector 32 and the connector connecting hole 46 being taken as a pivot point. That is, the receptacle connector 26 tilts down with the connecting portion with the connector connecting hole 46 being taken as the pivot point.

Subsequently, the receptacle connector 26 is moved outwardly as indicated by a blank arrow in FIG. 4. The plug connection opening 30a is positioned at a desired position facing the through-hole 55a. Finally, the fixing pieces 34a, 34b are fastened to the substrate 28, and the cover material 58 is attached to the chassis member 56. Hereby, the attachment operation of the receptacle connector 26 in the electronic apparatus 10 is completed.

In the meantime, the mounted substrate 12 of the present embodiment achieves a smooth removal operation of the receptacle connector 26 (described later). In view of this, the mounted substrate 12 is configured such that the relay connector 32 is attachable and detachable with the relay connector 32 being inclined diagonally upward from the depth direction of the connector connecting hole 46. More specifically, in the electronic apparatus 10 of the present embodiment, the relay connector 32 can be inserted into the connector connecting hole 46 along the extension line E1 of the inclined surface 49b (see FIG. 8). The extension line E2 in FIG. 8 is a virtual line parallel to the extension line E1 and passing through a bottom surface 26a of the receptacle connector 26. The electronic apparatus 10 of the present embodiment is preferably configured such that the extension line E1 of the inclined surface 49b does not intersect with the vertical wall 55. The electronic apparatus 10 is more preferably configured such that the extension line E2 does not intersect with the vertical wall 55 at a rotation position where the top surface (the other surface 40b) of the board piece 40 of the relay connector 32 makes contact with or comes closer to the inclined surface 49b. Hereby, the electronic apparatus 10 allows the receptacle connector 26 to be smoothly attached to and detached from the surface mount connector 27 while the electronic apparatus 10 avoids the receptacle connector 26 from interfering with the vertical wall 55 (see FIGS. 7 to 9).

Such an installation structure may be employed that no vertical wall 55 is provided near the surface mount connector 27 at the time when the mounted substrate 12 is incorporated into the chassis 14. There is also such a case where the receptacle connector 26 is connected to the surface mount connector 27 in a state where the mounted substrate 12 is not incorporated in the chassis 14. In those cases, it is not necessary that the receptacle connector 26 be diagonally connected to the surface mount connector 27. That is, the receptacle connector 26 can be connected in such a manner to be horizontally moved straight relative to the connector connecting hole 46 along the depth direction. Even in such a case, the ground pin 41a first makes contact with the first contact point 51, and therefore, the mounted substrate 12 can restrain the aforementioned electrostatic discharge damage.

Next will be described the removal operation of the receptacle connector 26 and its operation-effect.

In a state where the receptacle connector 26 is incorporated in the chassis 14, the receptacle connector 26 is mounted on the substrate 28 via the surface mount connector 27, as illustrated in FIG. 4. The fixing pieces 34a, 34b are fixed to the substrate 28 with screws.

When the receptacle connector 26 breaks down and is to be removed and replaced from this state, for example, the cover material 58 is first removed from the chassis member 56 (see FIG. 9). Hereby, the inside of the chassis 14 is exposed, so that the receptacle connector 26 becomes accessible. Respective screws fastening the fixing pieces 34a, 34b to the substrate 28 are removed. This causes the receptacle connector 26 to be supported on the substrate 28 only at a connecting portion between the relay connector 32 and the surface mount connector 27.

Subsequently, the receptacle connector 26 is pushed into the connector connecting hole 46 in a direction reverse to the blank arrow in FIG. 4. The receptacle connector 26 is pushed inward. In a state where the receptacle connector 26 is mounted as illustrated in FIG. 4, the mounted substrate 12 of the present embodiment has the clearance C2 between the depth surface 46a of the connector connecting hole 46 and the distal end surface 32a of the relay connector 32. This allows the receptacle connector 26 (the relay connector 32) to be moved only by the clearance C2 toward the deep side of the connector connecting hole 46.

The receptacle connector 26 is moved in a direction reverse to the blank arrow in FIG. 9. The receptacle connector 26 is lifted upward with the connecting portion between the relay connector 32 and the connector connecting hole 46 being taken as a pivot point. This causes the receptacle connector 26 to rotate such that an outermost end portion (the outer end surface 30b) draws an arc. That is, the receptacle connector 26 tilts up with the connecting portion with the connector connecting hole 46 being taken as the pivot point.

Then, the receptacle connector 26 is moved in a direction reverse to the blank arrows in FIGS. 8 and 7. The receptacle connector 26 is pulled outwardly and diagonally upward from the surface mount connector 27. Hereby, the removal operation of the receptacle connector 26 from the surface mount connector 27 is completed.

As such, in the mounted substrate 12 and the electronic apparatus 10 in the present embodiment, the receptacle connector 26 is not soldered to the substrate 28, so that the receptacle connector 26 can be easily replaced, thereby making it possible to restrain a replacement cost. Besides, the receptacle connector 26 can tilt up and tilt down relative to the surface mount connector 27. Hereby, the mounted substrate 12 and the electronic apparatus 10 can avoid such a situation that the vertical wall 55 becomes obstructive at the time of replacement of the receptacle connector 26, and the replacement operation can be performed more easily. Besides, the receptacle connector 26 has a horizontal engagement structure in which the receptacle connector 26 is engaged with the surface mount connector 27 in a direction along the surface direction of the substrate 28. Accordingly, the receptacle connector 26 is not stacked on the surface mount connector 27, so that the height of the mounted substrate 12 does not increase. As a result, the mounted substrate 12 also contributes to a reduction in the thickness of the chassis 14. Since the receptacle connector 26 has a horizontal engagement structure, it is possible to reduce the number of connecting points between the substrate 28 and the receptacle connector 26 and to shorten the length of an electrode line in the receptacle connector 26. On this account, the mounted substrate 12 is also suitable for transmission of high-speed signals.

In the meantime, in a state where the receptacle connector 26 of the present embodiment is attached as illustrated in FIG. 4, only the slight clearance C1 that is 0.2 mm, for example, is provided between the outer end surface 30b and the inner surface of the vertical wall 55. Hereby, the plug connection opening 30a of the receptacle connector 26 is placed close to the through-hole 55a, thereby preventing the clearance C1 from being outstanding at the time when the through-hole 55a is viewed from outside the chassis 14. In the meantime, assume a case where the receptacle connector 26 is tilted up or tilted down while the clearance C1 is maintained. In this case, the outer end surface 30b may make contact with the vertical wall 55, and the receptacle connector 26 may not be able to tilt up or tilt down to a desired angle. The reason is because the outer end surface 30b is placed below the connecting portion between the relay connector 32 and the connector connecting hole 46 which connecting portion serves as the pivot point for rotation.

In view of this, the electronic apparatus 10 of the present embodiment secures the clearance C2 on the deep side from the relay connector 32 in a normal connection state. Hereby, the receptacle connector 26 can be tilted up after the receptacle connector 26 is moved inward. In addition, the receptacle connector 26 can be tilted down after the receptacle connector 26 is pushed inward. Accordingly, the mounted substrate 12 can narrow the clearance C1 and also avoid the receptacle connector 26 from making contact with the vertical wall 55 at the time when the receptacle connector 26 is tilted up or tilted down.

In terms of the tilt-up operation, the mounted substrate 12 of the present embodiment can be configured such that the upper and lower edge portions 48a, 49a of the connector connecting hole 46 deviate from each other in the inside-outside direction. The open space S1 is formed in the opening edge portion of the connector connecting hole 46 due to the deviation. Accordingly, the mounted substrate 12 of the present embodiment allows the receptacle connector 26 to smoothly rotate in a state where the relay connector 32 is inserted into the connector connecting hole 46. Besides, the surface mount connector 27 can have the inclined surface 49b in the second edge portion 49a on the upper side of the open space S1. This restrains the rotating relay connector 32 from colliding with the second edge portion 49a of the surface mount connector 27. As a result, the receptacle connector 26 can be smoothly rotated to a desired angle illustrated in FIG. 8, for example.

As illustrated in FIGS. 8 and 9, the surface mount connector 27 can have the expansion space S2 expanding downward, on the deep side from the first contact point 51 in the connector connecting hole 46. Accordingly, it is possible to avoid the board piece 40 of the relay connector 32 from interfering with the first inner surface 48 in the connector connecting hole 46, thereby resulting in that the receptacle connector 26 further smoothly rotates.

As described above, the mounted substrate 12 of the present embodiment can restrain electrostatic discharge damage at the time when the relay connector 32 is connected to the surface mount connector 27. This is because the distal end of the ground pin 41a of the first terminal 41 projects toward the distal end side of the board piece 40 relative to the distal end of the high-speed transmission pin 41b or the like as a signal pin (see the distance L). The distance L allows the mounted substrate 12 to restrain the distal end of the signal pin (the high-speed transmission pin 41b or the like) from being stubbed in a state where the receptacle connector 26 is mounted on the substrate 28 as illustrated in FIG. 4.

More specifically, in the surface mount connector 27 of the present embodiment, the first contact point 51 is disposed closer to the opening side than the second contact point 52 in the depth direction of the connector connecting hole 46. In this configuration, assume a case where the relay connector 32 has a terminal structure similar to a connector having a general double sided terminal structure. In this case, the distal ends of all the pins 41a to 41h of the first terminal 41 are at the same position as the distal ends of the pins 42a to 42h of the second terminal 42 illustrated in FIG. 5B. Accordingly, in a case where the receptacle connector 26 is mounted on the substrate 28 as illustrated in FIG. 4, all the pins 41a to 41h are connected at positions protruding inwardly from the first contact points 51. As a result, a portion protruding in a branched manner from the high-speed transmission pin 41b or the high-speed reception pin 41c as a signal pin is formed in a signal transmission direction from the high-speed transmission pin 41b or the like to its connecting point with the first contact point 51. This causes the protruding portion of the signal pin such as the high-speed transmission pin 41b from the connecting point to become a stub that adversely affects transmission of high-speed signals. In this respect, the mounted substrate 12 of the present embodiment has the distance L described above and yields such an advantage that the formation of such a stub in a signal pin can be restrained, and transmission performance of high-speed signals can also improve.

Note that it is needless to say that the present invention is not limited to the above embodiment and is freely modifiable without departing from the gist of the present invention.

### Description of Symbols

- 10: electronic apparatus
- 12: mounted substrate
- 14: chassis
- 26: receptacle connector
- 27: surface mount connector
- 28: substrate
- 28a: mounting surface
- 30: plug hold cylindrical body
- 30a: plug connection opening
- 32: relay connector
- 41: first terminal
- 42: second terminal
- 48: first inner surface
- 48a: first edge portion
- 49: second inner surface
- 49a: second edge portion
- 49b: inclined surface
- 46: connector connecting hole
- 51: first contact point
- 52: second contact point
- 54: plate portion
- 55: vertical wall
- 55a: through-hole
- S1: open space
- S2: expansion space

## Claims

1. A mounted substrate (12) comprising:
a substrate (28) comprising a mounting surface (28a) ;
a surface mount connector (27) which comprises a connector connecting hole (46) opened along a surface direction of the substrate and which is mounted on the mounting surface of the substrate; and
a receptacle connector (26) comprising a plug connection opening (30a) to which a plug is connectable, the receptacle connector including a relay connector (32) detachably connected to the connector connecting hole, wherein:
the surface mount connector comprises
a first contact point (51) provided on a first inner surface (48) of the connector connecting hole which first inner surface is on one side in a height direction of the connector connecting hole, and
a second contact point (52) provided on a second inner surface (49) on the other side in the height direction;
the relay connector includes
a board piece insertable into the connector connecting hole,
a first terminal (41) provided on one surface of the board piece and connected to the first contact point, and
a second terminal (42) provided on the other surface of the board piece and connected to the second contact point;
the first contact point is disposed closer to an opening side than the second contact point in a depth direction of the connector connecting hole;
the first terminal includes a first ground pin and a first signal pin; and
the first ground pin comprises a distal end projecting toward a distal end side of the board piece relative to a distal end of the first signal pin.

2. The mounted substrate according to claim 1, wherein:
the second terminal includes a second ground pin and a second signal pin; and
the second ground pin comprises a distal end disposed at the same position as a distal end of the second signal pin.

3. The mounted substrate according to claim 1 or 2, wherein:
the first inner surface is a surface arranged closer to the mounting surface side in the height direction of the connector connecting hole; and
the second inner surface is a surface arranged opposite from the mounting surface side in the height direction of the connector connecting hole.

4. The mounted substrate according to claim 3, wherein:
the connector connecting hole comprises an opening edge portion including
a first edge portion (48a) as an edge portion of the first inner surface, and
a second edge portion (49a) as an edge portion of the second inner surface; and
the second edge portion is disposed closer to a deep side than the first edge portion in the depth direction of the connector connecting hole.

5. The mounted substrate according to claim 4, wherein the second edge portion comprises an inclined surface (49b) inclined in a direction separating from the mounting surface, from the deep side toward the opening side in the connector connecting hole.

6. The mounted substrate according to claim 4, wherein the connector connecting hole comprises an expansion space (S2) formed such that a portion of the first inner surface which portion is on the deep side relative to the first contact point is recessed toward the mounting surface side in the height direction.

7. An electronic apparatus (10) comprising:
a chassis (14); and
a mounted substrate (12) supported on the chassis, wherein:
the mounted substrate includes
a substrate (28) comprising a mounting surface (28a),
a surface mount connector (27) which comprises a connector connecting hole (46) opened along a surface direction of the substrate and which is mounted on the mounting surface of the substrate, and
a receptacle connector (26) comprising a plug connection opening (30a) to which a plug is connectable, the receptacle connector including a relay connector (32) detachably connected to the connector connecting hole;
the surface mount connector comprises
a first contact point (51) provided on a first inner surface (48) of the connector connecting hole which first inner surface is on one side in a height direction of the connector connecting hole, and
a second contact point (52) provided on a second inner surface (49) on the other side in the height direction;
the relay connector includes
a board piece insertable into the connector connecting hole,
a first terminal (41) provided on one surface of the board piece and connected to the first contact point, and
a second terminal (42) provided on the other surface of the board piece and connected to the second contact point;
the first contact point is disposed closer to an opening side than the second contact point in a depth direction of the connector connecting hole;
the first terminal includes a first ground pin and a first signal pin; and
the first ground pin comprises a distal end projecting toward a distal end side of the board piece relative to a distal end of the first signal pin.

8. The electronic apparatus according to claim 7, wherein:
the second terminal includes a second ground pin and a second signal pin; and
the second ground pin comprises a distal end disposed at the same position as a distal end of the second signal pin.

9. The electronic apparatus according to claim 7 or 8, wherein:
the first inner surface is a surface placed closer to the mounting surface side in the height direction of the connector connecting hole; and
the second inner surface is a surface placed opposite from the mounting surface side in the height direction of the connector connecting hole.

10. The electronic apparatus according to claim 9, wherein:
the chassis includes
a plate portion (54) configured to support a surface of the substrate which surface is opposite from the mounting surface, and
a wall (55) comprising a through-hole (55a) that the plug connection opening is disposed to face, the wall being provided in a standing manner from an edge portion of the plate portion; and
the connector connecting hole comprises an opening edge portion including
a first edge portion (48a) as an edge portion of the first inner surface, and
a second edge portion (49a) as an edge portion of the second inner surface; and
the second edge portion is disposed closer to a deep side than the first edge portion in the depth direction of the connector connecting hole.

11. The electronic apparatus according to claim 10, wherein:
the second edge portion comprises an inclined surface (49b) inclined in a direction separating from the mounting surface, from the deep side toward the opening side in the connector connecting hole; and
an extension line from the inclined surface does not intersect with the wall.

12. The electronic apparatus according to claim 10, wherein the connector connecting hole comprises an expansion space (S2) formed such that a portion of the first inner surface which portion is on the deep side relative to the first contact point is recessed toward the mounting surface side in the height direction.
